# EUROPEAN PATENT APPLICATION

(11) **EP 2 327 524 A1**
(43) Date of publication of application: **01.06.2011**
(21) Application number: 09814741.6
(22) Date of filing: 26.08.2009
(51) Int. Cl.: B29C 33/42, B29C 59/02, B29C 45/27, B29C 45/26

(54) **A STAMPER INCLUDING A MICRO PATTERN**

(30) Priority: 22.09.2008 KR 20080092698
(71) Applicant: LG Electronics Inc., Seoul 150-721 (KR)
(72) Inventor: JEONG, Seok Jae, Changwon-si Gyeongsangnam-do 641-711 (KR); KIM, Young Bae, Changwon-si Gyeongsangnam-do 641-711 (KR)
(74) Representative: Palmer, Jonathan R.
(86) International application number: PCT/KR2009/004751
(87) International publication number: WO 2010/032925

(57) **Abstract**

The present invention relates to stampers having micro patterns, and more specifically, the present invention relates to a stamper which enables to emit a color or form a character or a predetermined shape on a surface of an injection molded product owing to a pattern in a case the pattern is formed on the injection molded product by the stamper.

The stamper includes a stamper body, a plurality of micro patterns formed on a surface of the stamper body to be brought into contact with a surface of a product for the surface of the product to have a color or a shape, and spaces between the micro patterns.

## Description

### [TECHNICAL FIELD]

The present invention relates to stampers having micro patterns, and more specifically, the present invention relates to a stamper which enables to emit a color or form a character or a predetermined shape on a surface of an injection molded product owing to a pattern in a case the pattern is formed on the injection molded product by the stamper.

### [BACKGROUND ART]

In a course of development of home appliances, though it has been a trend that the home appliances are developed focused on functions of the products or convenience of the users, moving further from the trend, currently a trend takes place, in which a user's sense of beauty is taken into account keeping a consumer's sense in mind.

As a result of this, though related art home appliances have exteriors of achromatic colors, such as a white color, without patterns, recently the home appliances are made, not only to provide convenience of life to the users, but also to become a portion of an interior design by making colorful decoration of the exterior of the home appliances and the exterior to become more splendid by using ornaments.

Especially, in a case the home appliance which forms a large empty front space, such as a refrigerator and an air conditioner, by placing a decorative panel on the front, the sense of beauty can be enhanced.

### [DISCLOSURE OF INTENTION]

### [TECHNICAL PROBLEM]

In the meantime, in decoration of the home appliance thus, a step is required, in which a color panel is placed on the home appliance directly and placing an ornament therein, and if characters are required at such a portion, a step for carving the characters therein is required.

Since such an addition of the steps costs time and expense, a technology that can minimize such a cost has been required.

### [TECHNICAL SOLUTION]

To solve the problems, an object of the present invention is to provide a stamper which can make easy generation of a color or easy formation of character or shape on a surface of a product.

To achieve these objects and other advantages and in accordance with the purpose of the invention, as embodied and broadly described herein, a stamper includes a stamper body, a plurality of micro patterns formed on a surface of the stamper body to be brought into contact with a surface of a product for the surface of the product to have a color or a shape, and spaces between the micro patterns.

The micro patterns include widths of the micro patterns or pitches between the micro patterns of 0.2µm ∼ 20µm which enable to emit a color from the surface of the product.

The micro patterns include widths of the micro patterns or pitches between the micro patterns of 20µm ∼ 1000µm which enable to form a shape on the surface of the injection molded product.

The micro patterns include a linear shape.

The micro patterns include a shape surrounding a center point at the stamper so that the shape varies a color or a shape depending on a direction of a light incident on the micro patterns.

The micro patterns have circular shapes.

The micro patterns have hexagonal shapes.

The micro patterns have square shapes.

The stamper includes micro patterns having widths and pitches varied between parts thereof for varying colors emitting therefrom with positions of a light incident on the micro patterns.

### [ADVANTAGEOUS EFFECTS]

The present invention has following advantageous effects.

If a color or a shape is required on a product, by transcribing the micro patterns on the stamper to the product, the color or the shape can be formed easily without forming the required shape or painting the color on the product.

By making a color varied with an angle of view, a sense of beauty of the product can be enhanced.

### [BRIEF DESCRIPTION OF THE DRAWINGS]

FIGS. 1 and 2 illustrate sections showing the steps of a method for fabricating a stamper in accordance with a preferred embodiment of the present invention;
FIG. 3 illustrates stampers each having a micro-pattern with the same pitches;
FIG. 4 illustrates stampers each having a micro-pattern with pitches different from one another;
FIGS. 5 to 8 illustrate the steps of a method for transcribing a micro pattern by using a stamper having the micro pattern and an injection molding; and
FIGS. 9A ∼ 9C illustrate photographs of products each having a micro pattern transcribed thereto.

### [BEST MODE]

Reference will snow be made in detail to the specific embodiment of the present invention, examples of which are illustrated in the accompanying drawings.

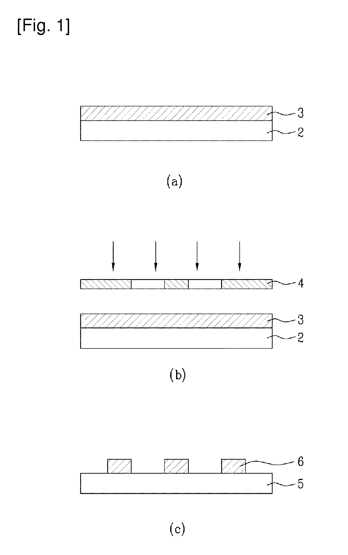

A method for fabricating a stamper in accordance with a preferred embodiment of the present invention will be described with reference to FIG. 1.

Referring to FIG. 1A, a sensitizing solution 20 is coated on a flat substrate 10 for forming a desired pattern. Then, as shown in FIG. 1B, a mask 30 having a required pattern formed thereon is placed on the flat substrate 10, and an exposure is made to an upper side of the mask, to form a pattern 40 opposite to the pattern printed on the mask 30 on the flat substrate 10 at an upper side thereof.

It is preferable that the pattern 40 has a nano sized or a micro sized pattern.

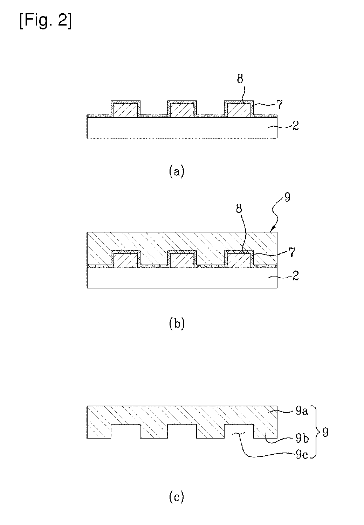

Referring to FIG. 2A, for making electroforming required for fabrication of the stamper, a metal seed layer 50 of a fixed thickness is coated on the substrate 10 and the pattern 40, as shown in FIG. 2B, a structure 60 of nickel Ni or copper Cu is formed by electroforming on the micro pattern having the metal seed layer 50 coated thereon to cover the micro pattern and the metal seed layer 50, and, as shown in FIG. 2C, if the structure 60 is taken off the substrate, the stamper 60 having the desired pattern can be fabricated.

In this instance, the stamper 60 includes a stamper body 60 which forms a body of the stamper 60, a micro pattern 62 on a surface of the stamper body 60 for transcribing the pattern 40, and a space 63 between the micro patterns.

However, the stamper may have a variety of the micro patterns to vary patterns on a surface of the product which is formed as the stamper is brought into contact thereto for producing variation of colors depending on an angle of view on the product.

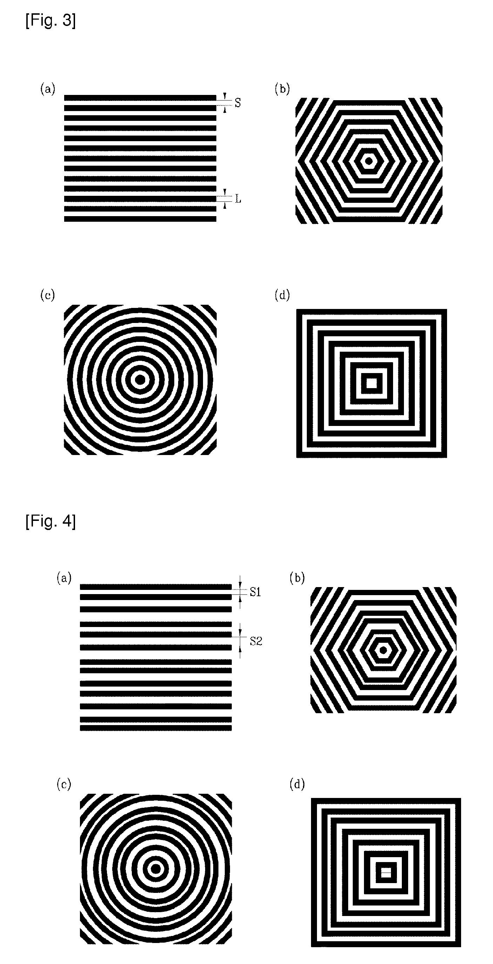

The micro pattern can be a linear pattern as shown in FIG. 3A, or hexagonal, or circular, or square patterns as shown in FIGS. 3B, 3C, or 3D, respectively.

The variety of micro patterns are arranged for mounting a product having the micro patterns transcribed thereto to a portion where decoration is required for producing a hologram effect in which a color vary with an angle of view when the user looks at the portion from an outside of the product.

A light has characteristics of a particle as well as a wave, showing an interference phenomenon which is a characteristic of the wave. The interference is a phenomenon in which amplitude of a wave is augmented (Constructive interference) when phases of the wave are the same, and the amplitude of the wave is diminished (Destructive interference) when phases of the wave are opposite. If a white color meets with a medium to cause interference, a particular wave band causes constructive interference and other wave band causes destructive interference, to display colors.

If the light transmitting through the air meets with other medium, i.e., a structure of the micro pattern, a portion thereof is reflected and the other portion thereof passes the micro pattern. In this instance, the light passed through the micro pattern meets with the next micro pattern, resulting in a portion thereof to be reflected and the other portion thereof to pass the micro pattern. Such steps are repeated for a number of times.

In this instance, in each of the steps, if the reflected light has a phase the same with a phase of an incident light, the constructive interference takes place, and if the reflected light has a phase opposite to a phase of the incident light, the destructive interference takes place.

In the meantime, sometimes the color changes or disappears depending on the structure of the micro pattern. If an interval of the micro patterns on the stamper is adjusted, to make the interval to be formed on the product greater or smaller, the path of the light is changed, to cause the constructive interference, i.e., a wavelength of the reflected light is also changed. Depending on an angle of the light incident on the micro pattern, a color of the reflected light also changes.

By taking the micro pattern, the characteristic of the light incident on the micro pattern, and a direction of user's eyes, i.e., an indent direction of the light, into account, and by adjusting pitches of the micro patterns and widths of the micro patterns, it is possible that a color is sensed externally, and the color varies with the direction of eyes.

In this instance, it is preferable that the width Land the pitch S between the micro patterns at which the color can be displayed are set to be 0.2µm ∼ 20µm taking a wavelength of the light incident thereto from an outside, particularly, the wavelength of the visible light into account. In this instance, the width and the pitch of the micro pattern may vary partly throughout the stamper, for making the color of the light emitted from different parts to vary.

In the meantime, besides making the color to emit from the surface of the product having the micro pattern transcribed thereto as described before, by making the width and the pitch of the micro pattern greater than the width and the pitch of the micro pattern at which the micro pattern emits the color, it is possible to form a shape, such as a character, on the product.

In this instance, it is preferable that the micro pattern is formed such that the micro pattern can reflect entire wavelengths of the visible light, to reflect the incident light to an outside in a state the entire wavelengths of incident light are superimposed so that a portion where the micro pattern is formed appears to have colors of a white group.

For this, it is preferable that the width L and the pitch S of the micro pattern is set to be 20 ∼ 2000µm.

In the meantime, FIG. 4 illustrates stampers each having a micro-pattern with pitches S1 and S2 different from one another, to make the incident light onto the stamper different depending on incident positions for varying colors emitted from respective parts.

A method for fabricating a product by using a stamper having a micro pattern will be described. Though there are hot stamping and injection molding in the method, the following description will be based on the injection molding which enables fast production of the product.

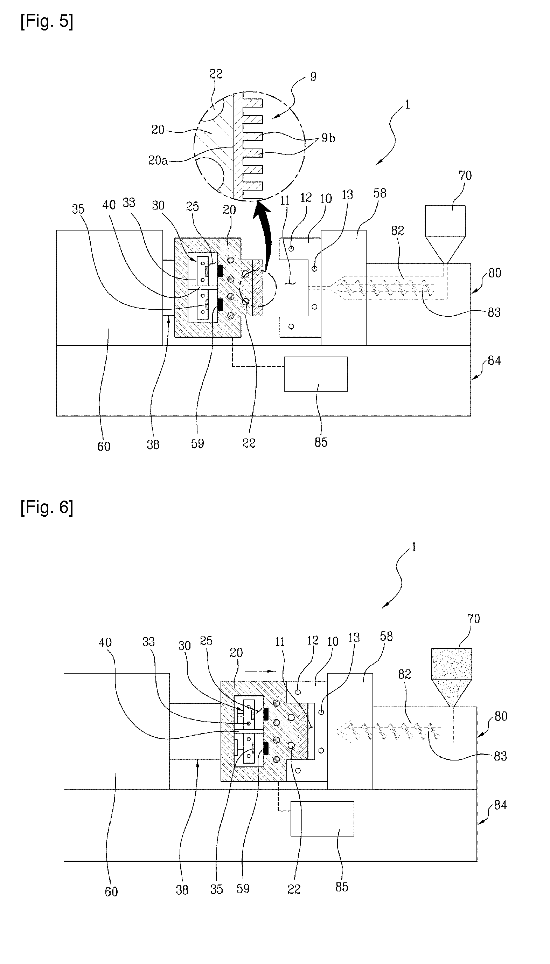

Referring to FIG. 5, the injection molding machine 1 having the stamper with the micro pattern of the present invention includes a first mold unit 10, a second mold unit 20, and the first mold unit 10 has a cavity 11 for introducing molten resin thereto.

It is preferable that the first mold unit 10 has a heating unit, such as a first heater 13, mounted therein for preventing the resin from solidifying at the time of injection molding, and a cold water flow passage 12 built therein for flow of cooling water.

The second mold unit 20 has a second heater 22 mounted therein for heating the second mold 20, and a cooling mold 30 in rear of the second heater 22 for cooling the second mold 20.

The cooling mold 30 is movably arranged at a receiver 25 mounted in the second mold 20 separately, and the receiver 25 has a guide member 40 for guiding movement of the cooling mold 30.

The cooling mold 30 and the second mold 20 have an electric magnet 35 and a permanent magnet 59 arranged thereto respectively. If the electric magnet 35 and the permanent magnet 59 are arranged thus and a current is applied to the electric magnet 35, an attractive force or repulsive force is generated between the electric magnet 35 and the permanent magnet 59. If the attractive force is generated, the cooling mold 30 and the second mold 20 are brought into contact to cool down the second mold 20.

The cooling mold 30 has a cooling water flow passage 33 formed therein for flow of cooling water. If cooling of the second mold unit 20 is required, the cooling water is introduced to the cooling water flow passage 33 to cool down the second mold unit 20 and the stamper 9 to be described later quickly, causing solidification of the resin filled in the first and second mold units 10 and 20, to form a molded product.

At a side of the first mold unit 10, there is a first mold supporting block 58, and there is a second mold supporting block a spaced a distance away from the first mold supporting block 58 for supporting the second mold unit 20.

In rear of the second mold 30, there is a mold moving unit 38 projected from the second mold supporting block 60 for making the second mold 20 to move to or move away from the first mold unit 10.

On one side of the first mold supporting block 58, there is a resin supply unit 80 for moving molten resin to the first mold unit 10, and over the resin supply unit 80, there is a hopper 70 for receiving the molten resin.

In this instance, it is preferable that there are a resin flow passage 82 provided to pass through the resin supply unit 80, the first mold supporting block 60, and the first mold unit 10 for guiding the molten resin from an outlet of the hopper 70, with a screw 83 arranged therein for making quick transfer of the molten resin to the first mold unit 10.

Under the first and second mold supporting blocks 58 and 60 and the resin supply unit 80, there is a base block 84 for supporting them.

In the meantime, at one side of the second mold unit 20, there is the stamper 9 having the micro pattern 9b provided thereto, and at a surface of one side of the second mold unit 20, there is a stamper attachment portion 20a provided thereto for attaching the stamper thereto.

Though the drawing shows an enlarged view of the micro pattern 9b on the stamper for showing the micro pattern 9b clearly, the micro pattern 9b is invisible with naked eyes.

It is preferable that the stamper attachment portion 20a has a fixture, such as a holder (not shown) or a jig (not shown) for fastening the stamper not to make position change when the stamper 9 and the molten resin are brought into contact with each other in the injection molding.

The stamper 9, formed of a metal like nickel, has in general a surface temperature significantly lower than the molten resin used in the injection molding.

Therefore, since there is a problem in that the resin solidifies before the micro pattern 9b is patterned to resin perfectly if the stamper 9 having a relatively low temperature and the molten resin having a high temperature are brought into contact, it is required to maintain the stamper 9 to be at a temperature higher than a glass transition temperature of the polymer of the resin.

The glass transition temperature is a temperature at which a polymer becomes to have activity and begins to move. The polymer resin is in a solid state at a temperature below the glass transition temperature, and if the polymer resin is at a temperature higher than the glass transition temperature, the polymer resin turns to have elasticity, like rubber, and if the temperature becomes higher, the polymer resin turns to liquid at the end.

Accordingly, it is required that a liquid state of the resin is maintained for a predetermined time period for forming a pattern the same with the micro pattern on the stamper on an injection molded product exactly as the liquid state resin is brought into contact with the stamper 9. Therefor, it is required that a surface temperature of the stamper is at the glass transition temperature for the time period.

In the meantime, a temperature control unit 85 is provided to the base block 84 of the injection molding machine.

Since a main purpose of the cooling mold 30 and the second heater 22 mounted to the second mold unit 20 is fast heating and fast cooling of the stamper 9, mostly the temperature control unit 85 serves to make fast temperature control of the surface of the stamper 9.

Injection molding with the stamper 9 having the micro pattern 9b formed thereon in accordance with a first preferred embodiment of the present invention will be described.

Referring to FIG. 6, the stamper 9 having the micro pattern 9b is fastened to the stamper attachment portion 20a of the second mold unit 20. Then, upon applying an instruction that the surface temperature of the stamper 9 and the first and second mold units 10 and 20 are to be higher than a predetermined temperature to an operational button, a current flows to the first and second heaters 13 and 22 to heat the first and second mold units 10 and 20 by heat resistance, along with the stamper 9 to be higher than the predetermined temperature.

In general, a time period in which the stamper 9 reaches to the predetermined temperature, for an example, the glass transition temperature, is around one minute from right after the heaters are put into operation.

In this instance, since current flows to the electric magnet 35 to generate repulsive force between the permanent magnet 28 and the electric magnet, the second mold 20 and the cooling mold 30 maintain a spaced state.

Referring to FIG. 6, while the second mold unit 20 and the cooling mold 30 maintain the spaced state thus, and the first and second mold units 10 and 20 and the stamper 9 maintain the heated state, if the second mold unit 20 moves to the first mold unit 10 until the second mold unit 20 and the first mold unit 10 are brought into close contact, an enclosed cavity 11 of a shape of the product is formed between the first mold unit 10 and the stamper 9.

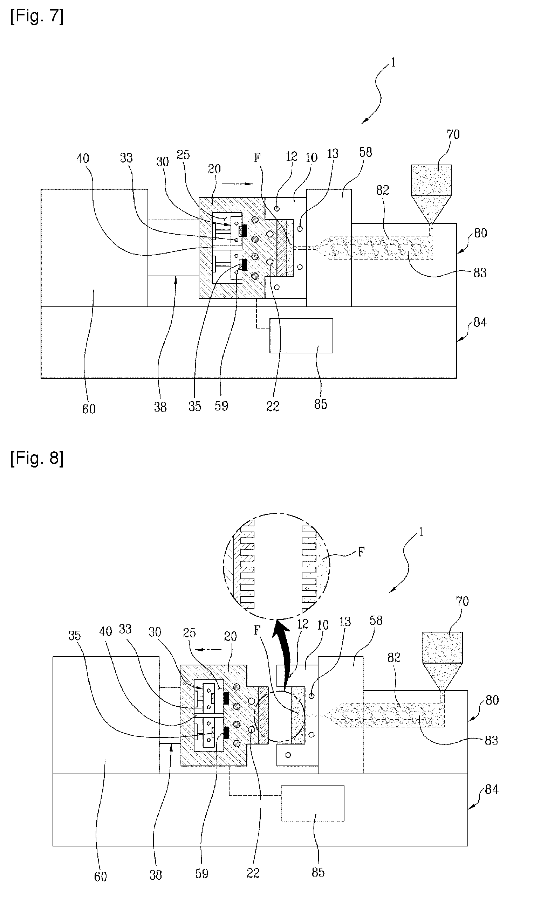

Referring to FIG. 7, in a state the second mold unit 20 and the first mold unit 10 are in close contact to form the enclosed cavity 11, the molten resin R is introduced to the cavity 11 by means of the screw 83 moving in the resin flow passage 82 to fill the cavity 11 and between the micro patterns 9b on the stamper 9, to transcribe the micro pattern 9b as it is.

Then, if the first and second heaters 13 and 22 are turned off, and a repulsive force is generated between the electric magnet 35 and the permanent magnet 59, the cooling mold 30 is brought into contact with the second mold 20, and at the same time with this, if the cooling water is introduced to the cooling water flow passage 33 in the cooling mold 30 and the cooling water flow passage 12 in the first mold 10, the first and second mold units 10 and 20 and the stamper 9 are cooled, to solidify the resin filled in the cavity 11.

Then, referring to FIG. 8, the second mold unit 20 is moved away from the first mold unit 10, to obtain the injection molded product F having the micro pattern 9b on the stamper 9 transcribed thereto from the cavity 11.

As described before, by varying the pitch and width of the micro pattern on the stamper 9, a color from a surface of the injection molded product F can vary.

In the meantime, besides the injection molding, the product can be obtained by so called hot stamping in which a heated stamper is brought into contact with a resin product to transcribe the micro pattern on the stamper to the surface of the resin product.

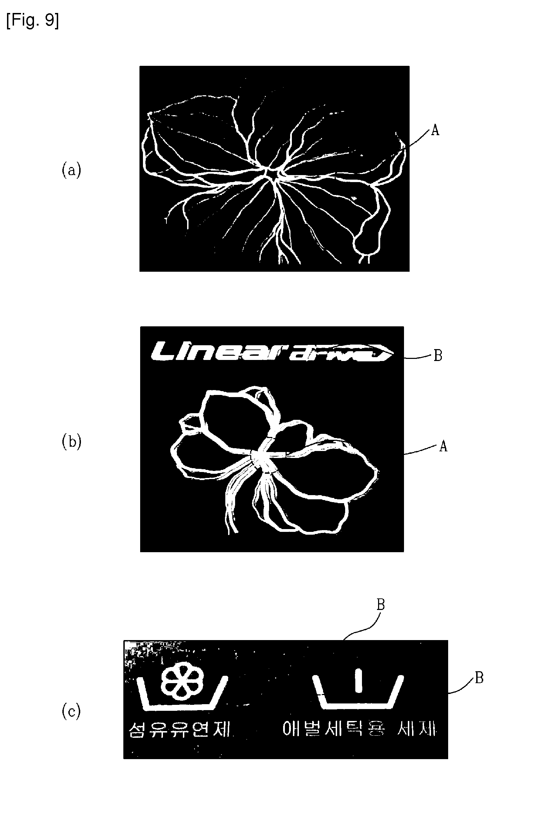

FIGS. 9A ∼ 9C illustrate photographs of products each having a micro pattern transcribed thereto so as to emit a color or form a shape.

FIG. 9A illustrates an ornamental panel made to emit a color by using a stamper having a micro pattern, wherein petal shaped outline portions are made to emit the color by using the stamper.

As described, a portion indicated with A has micro patterns with 0.2 ∼ 20µm pitches which emits a color.

FIG. 9B illustrates an ornamental panel having a portion emitting a color and a portion displaying characters, wherein an A portion emitting a color has micro patterns with 0.2 ∼ 20µm pitches, and B portion displaying characters has micro patterns with 20 ∼ 2000µm pitches.

FIG. 9C illustrates a panel having characters and figures displayed in a white color, wherein portions of the characters and the figures are formed by a stamper having micro patterns with 20 ∼ 2000µm pitches.

## Claims

1. A stamper comprising:
a stamper body;
a plurality of micro patterns formed on a surface of the stamper body to be brought into contact with a surface of a product for the surface of the product to have a color or a shape; and
spaces between the micro patterns.

2. The stamper as claimed in claim 1, wherein the micro patterns include widths of the micro patterns or pitches between the micro patterns of 0.2µm ∼ 20µm which enable to emit a color from the surface of the product.

3. The stamper as claimed in claim 1, wherein the micro patterns include widths of the micro patterns or pitches between the micro patterns of 20µm ∼ 1000µm which enable to form a shape on the surface of the injection molded product.

4. The stamper as claimed in one of claims 1 to 3, wherein the micro patterns include a linear shape.

5. The stamper as claimed in one of claims 1 to 3, wherein the micro patterns include a shape surrounding a center point at the stamper so that the shape varies a color or a shape depending on a direction of a light incident on the micro patterns.

6. The stamper as claimed in claim 5, wherein the micro patterns have circular shapes.

7. The stamper as claimed in claim 5, wherein the micro patterns have hexagonal shapes.

8. The stamper as claimed in claim 5, wherein the micro patterns have square shapes.

9. The stamper as claimed in claim 1, wherein the stamper includes micro patterns having widths and pitches varied between parts thereof for varying colors emitting therefrom with positions of a light incident on the micro patterns.
